Europäisches Patentamt

European Patent Office

Office européen des brevets

(11) Veröffentlichungsnummer: **0 379 253**
**A2**

(12) # EUROPÄISCHE PATENTANMELDUNG

(21) Anmeldenummer: **90200093.4**

(51) Int. Cl.⁵: **H03K 17/969**

(22) Anmeldetag: **15.01.90**

(30) Priorität: **19.01.89 DE 3901419**

(43) Veröffentlichungstag der Anmeldung:
**25.07.90 Patentblatt 90/30**

(84) Benannte Vertragsstaaten:
**DE FR GB IT**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB IT**

(72) Erfinder: **Nussbaum, Hans-Georg**
**verstorben**
**.(DE)**
Erfinder: **Schmücker, Manfred**
**Narzissenweg 5**
**D-5242 Kirchen 5(DE)**
Erfinder: **Hissel, Leopold Heinrich, Ir.**
**Klooster Straat 51**
**NL-5513 AH Wintelre(NL)**

(74) Vertreter: **Erdmann, Anton et al**
**Philips Patentverwaltung GmbH**
**Wendenstrasse 35**
**D-2000 Hamburg 1(DE)**

(54) **Tastatur für ein elektrisches Gerät.**

(57) Die Erfindung bezieht sich auf eine Tastatur für ein elektronisches Gerät, z. B. für eine elektronische Datenverarbeitungsanlage, zur Beeinflussung von elektrischen Stromkreisen beim Betätigen der Tasten. Um eine derartige Tastatur zu vereinfachen und störunanfälliger zu gestalten, wird vorgeschlagen, daß die Tasten auf einer mit Lichtleitern versehen Trägerplatte angeordnet werden, daß die Lichtleiter unterhalb jeder Taste zum Einführen eines von der Taste betätigbaren Schiebers unterbrochen sind und daß die Lichtleiter mit Lichtquellen und Lichtempfängern verbindbar sind.

Fig. 2

## Tastatur für ein elektrisches Gerät

Die Erfindung bezieht sich auf eine Tastatur für ein elektrisches Gerät, z. B. für eine elektronische Datenverarbeitungsanlage, zur Beeinflussung von elektrischen Stromkreisen beim Betätigen der Tasten.

Für die elektronische Datenverarbeitung sind verschiedene Tastaturprinzipien bekannt und im Einsatz, z. B. Read-Kontakte, Folienkontakte oder ähnliche Mechanismen. Diese Anordnungen haben u. a. den Nachteil, daß sie eine aufwendige Steuerelektronik benötigen und mehr oder weniger störanfällig sind. Außerdem ist die Lebensdauer durch den mechanischen Kontakt beschränkt. Weiterhin neigen die genannten Schaltmechanismen zu Prellerscheinungen, die durch elektrische Schaltungen unterdrückt werden müssen.

Der Erfindung liegt die Aufgabe zugrunde, eine Tastatur der eingangs genannten Art zu vereinfachen und die Störanfälligkeit zu vermindern. Diese Aufgabe wird bei einer Bauart der eingangs genannten Art dadurch gelöst, daß die Tasten auf einer mit Lichtleitern versehenen Trägerplatte angeordnet sind, daß die Lichtleiter unterhalb jeder Taste zum Einführen eines mit der Taste betätigbaren Schiebers unterbrochen sind und daß die Lichtleiter mit Lichtquellen und Lichtempfängern verbindbar sind. Die genannte Trägerplatte dient sowohl durch Ausgestaltung mit der nötigen Festigkeit zur Befestigung der Tasten als auch zur Aufnahme einer großen Anzahl von Lichtleitern. In diese Lichtleiter wird Licht von lichtaussendenden Elementen eingekoppelt, und aus den Lichtleitern wird das Licht wieder zu lichtempfangenden Elementen ausgesendet, wobei die einzelnen Leiterbahnen jeweils ein Tastenelement unterlaufen und an dieser Stelle durch die Betätigung der Taste prellungsfrei und verschleißfrei unterbrochen werden. Diese Anordnung erfordert somit keine speziellen Schaltelemente, die die oben genannten Nachteile aufweisen, und ermöglicht somit eine kontaktlose Ankopplung einer zugehörigen elektronischen Schaltanordnung an die optischen Schaltelemente. Diese sind außerdem verschleiß- und prellfrei. Die Lichtleiter sind jeweils unterhalb einer Taste unterbrochen. Dadurch kann beim Betätigen der Taste ein mit der Taste verbundener Schieber abgesenkt und ein von dem Lichtleiter geführter Lichtstrahl unterbrochen werden. Der Abstand zwischen den beiden einander gegenüberliegenden Leiterenden an einer derartigen Unterbrechungsstelle soll so klein wie möglich gehalten werden, um die an den Lichtaus- und -eintrittsflächen auftretende Dämpfung so gering wie möglich zu halten.

Die Trägerplatte ist in Ausgestaltung der Erfindung vorzugsweise ein Kunststoffspritzteil mit eingeprägten Kanälen zur Aufnahme der Lichtleiter. Diese können vorzugsweise in einem Mehrspritzverfahren oder durch Eingießen eines lichtleitenden Gels hergestellt werden. In weiterer Ausgestaltung der Erfindung ermöglicht die Verwendung von verschiedenen Materialien mit unterschiedlichen Brechungsindizes sowie eine hohe Oberflächengüte eine dämpfungsarme Lichtleitung durch die eingespritzten Lichtleiter. Die Trägerplatte kann auch eingefärbt werden, um dadurch die Dämpfung innerhalb der nicht für die Lichtleitung benötigten Räume zu vergrößern und ein Nebensprechen zwischen verschiedenen Lichtleitern zu verringern.

Eine bevorzugte Bauart besteht darin, daß die Lichtleiter mit den zugehörigen Tasten auf der Trägerplatte in Form einer Matrix angeordnet und derart mit Lichtquellen und Lichtempfängern verbunden sind, daß jede Lichtqelle über einen gesonderten, durch je eine Taste unterbrechbaren Lichtleiter mit jedem Lichtempfänger verbunden ist. Diese Anordnung ermöglicht mit einer zugehörigen angepaßten Elektronik die Ausführung eines n-Key-Rollovers, da die einzelnen Tasten voneinander völlig entkoppelt sind. Eine kompakte, wenig Platz beanspruchende Bauart ergibt sich in weiterer Ausgestaltung der Erfindung dadurch, daß die die Lichtleiter enthaltende und die Tasten tragende Trägerplatte auf einer die zugehörige Elektronik enthaltenden Platine befestigt ist und daß der mit der Elektronik-Platine galvanisch verbundene Lichtsender und/oder -empfänger in eine Öffnung der Trägerplatte ragt, in die die Enden der Lichtleiter einmünden. Diese Anordnung benötigt keine Steckkontakte, die häufig zu Problemen Anlaß geben. Durch eine geschickte Leiterführung kann erreicht werden, daß sämtliche Lichtempfänger und Lichtsender auf einer einzigen Elektronik-Platine angeordnet werden. Eine weitere Ausgestaltung der Erfindung besteht darin, daß der Schieber einer Taste mehr oder weniger lichtdurchlässig, z. B. grau eingefärbt ist. Durch die Verwendung derartiger grau getönter Tastenschieber können mehrere Schaltelemente in einen Lichtstrahlweg eingebaut werden. Unterschiedliche Grautönungen an den halbdurchlässigen Schiebern der Tasten ermöglichen durch eine Detektierung des Lichtniveaus am Empfänger eine eindeutige Zuordnung der gedrückten Taste.

In der Zeichnung ist der Gegenstand der Erfindung in den Fig. 1 bis 7 schematisch dargestellt.

Fig. 1 zeigt in einer Draufsicht und in einem Schnitt einen Ausschnitt aus einer Trägerplatte mit einem Lichtleiter,

Fig. 2 zeigt eine perspektivische Darstellung einer Taste im Bereich einer Leiterbahn,

Fig.3 zeigt eine Matrixanordnung verschiedener Tasten,

Fig. 4 zeigt eine Ansteuerung der Lichtquellen gemäß Fig. 3,

Fig. 5 zeigt zwei Beispiele für eine Ein- und Auskopplung in zirkularer und planarer Bauart,

Fig. 6 zeigt im Schnitt eine mit einer Elektronik-Platte verbundene Trägerplatte, und

Fig. 7 zeigt in zwei Ansichten ein Schieberelement für eine Taste.

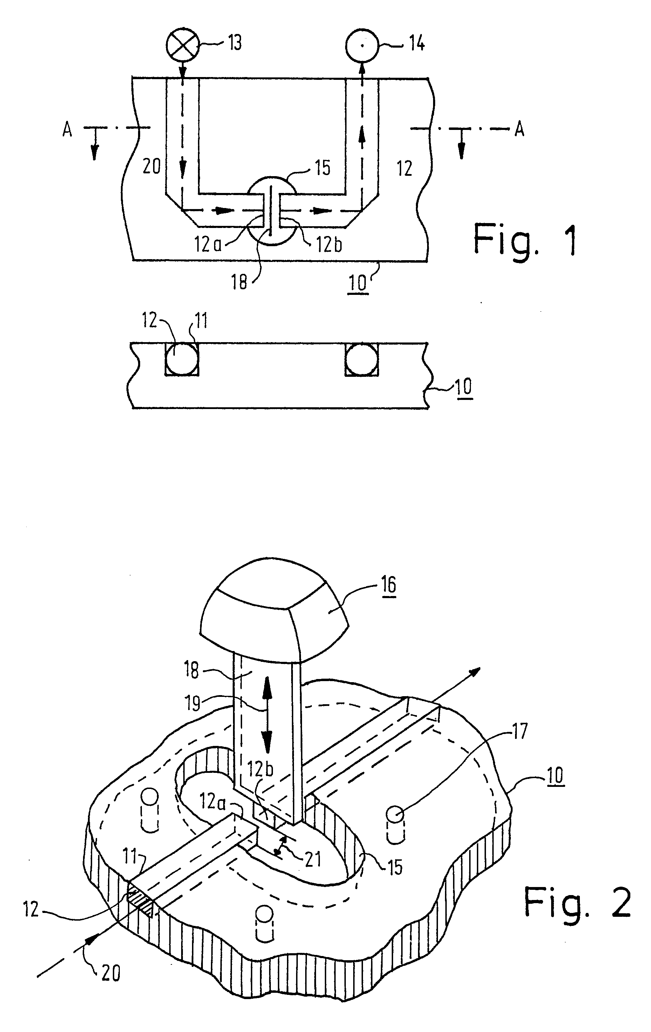

Fig. 1 zeigt einen Ausschnitt aus einer Trägerplatte 10 mit einem in einem Kanal 11 geführten Lichtleiter 12. Mit 13 ist eine Lichtquelle und mit 14 ein Lichtempfänger zum Ein- und Auskoppeln von Licht bezeichnet. Der Kanal 11 und der Lichtleiter 12 sind im Bereich einer Aussparung 15 innerhalb der Trägerplatte 10 unterbrochen, wie insbesondere aus Fig. 2 deutlich erkennbar ist. Die Trägerplatte 10 besitzt eine Vielzahl von Tasten 16, die über Montagelöcher 17 in nicht dargestellter Weise auf der Trägerplatte 10 befestigt sind. Die Taste 16 besitzt einen flachen Schieber 18 und kann in Pfeilrichtung 19 betätigt werden. Mit 20 ist ein im Lichtleiter 12 geführter Lichtstrahl dargestellt. Der Lichtleiter 12 ist im Bereich der Aussparung unterbrochen, wobei sich die beiden Stirnflächen 12a und 12b mit einem geringen Abstand 21 gegenüberliegen. Bei Betätigung der Taste 16 schiebt sich der Schieber 18 zwischen die beiden Stirnflächen 12a und 12b, so daß der Lichtstrahl 20 unterbrochen ist.

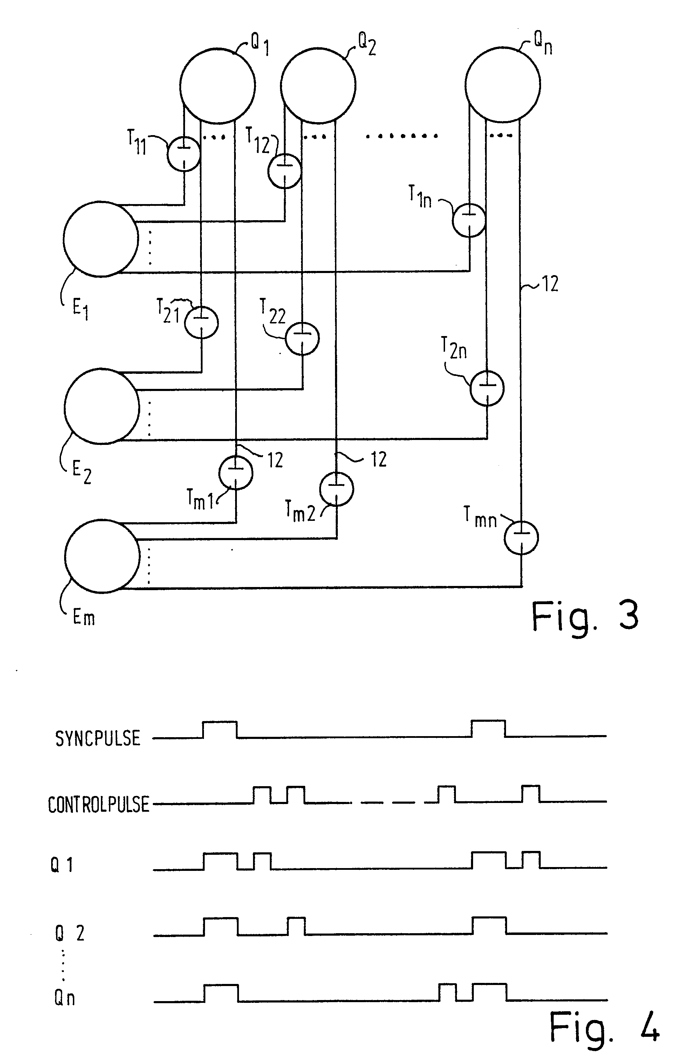

Die Tasten-Bauelemente werden auf der Trägerplatte in Form einer Matrix angeordnet, wie dies in Fig. 3 im Prinzipschema dargestellt ist. Hierbei sind die Lichtquelle jeweils mit Q, die Lichtempfänger mit E und die Tastenelemente mit T bezeichnet. Es ist ersichtlich, daß die einzelnen Lichtquellen $Q_l$ bis $Q_n$ ihr Licht in m Lichtleiter einkoppeln, die jeweils durch eine Taste $T_{mn}$ unterbrochen werden. Diese Anordnung ermöglicht mit einer zugehörigen angepaßten Elektronik die Ausführung eines n-Key-Roll-overs, da die einzelnen Tasten voneinander völlig entkoppelt sind.

Fig. 4 zeigt ein Beispiel der Steuerung der Lichtquellen $Q_l$ bis $Q_n$ gemäß Fig. 3. Durch einen Steuerimpuls und durch einen in der Zeit verschobenen Puls der Lichtquelle $Q_i$ kann am Empfänger $E_j$ eindeutig ermittelt werden, welche Tasten $T_{ij}$ betätigt wurden.

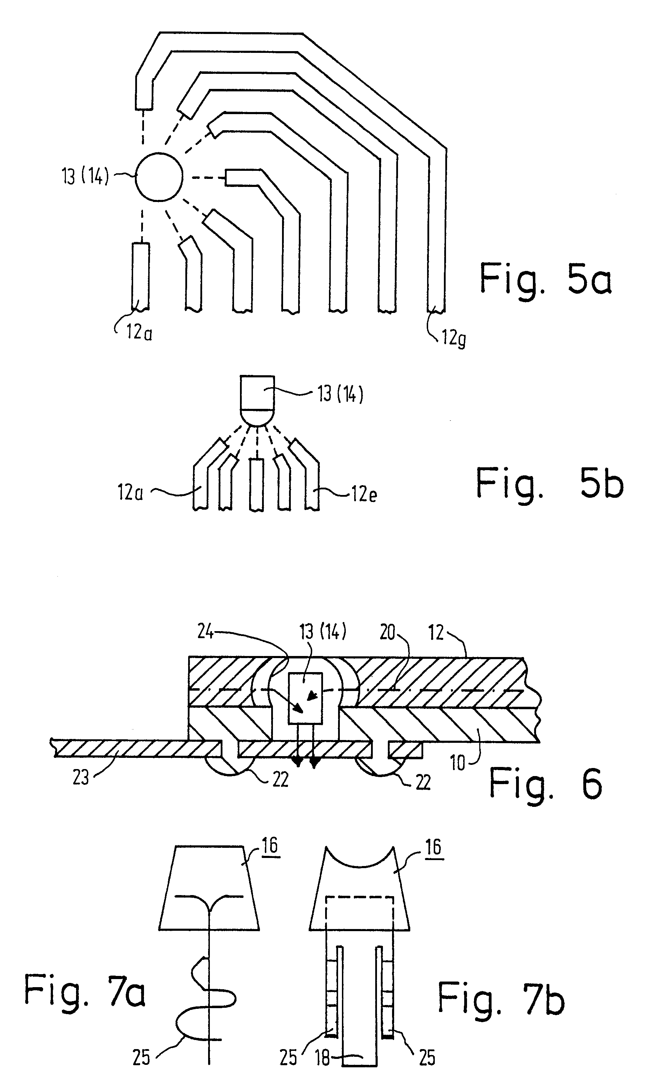

Fig. 5a zeigt ein Beispiel für eine zirkulare Ein- bzw. Auskopplung von Licht. Mit 13 bzw. 14 ist eine Lichtquelle bzw. ein Lichtsender, und mit 12a, 12b usw. sind Lichtleiter bezeichnet, die etwa kreisförmig um die Quelle bzw. den Empfänger angeordnet sind. In der Zeichnung Fig. 5b ist eine planare Anordnung der Leiter 12a bis 12e um eine Lichtquelle 13 bzw. einen Lichtsender 14 dargestellt.

Fig. 6 zeigt die mit den Lichtleitern 12 versehene Trägerplatte 10, die über Befestigungsmittel 22 mit einer Elektronik-Platine 23 verbunden ist. Ein Lichtsender bzw. Lichtempfänger 13, 14 ist galvanisch mit der Elektronik-Platine 23 verbunden und ragt in eine Öffnung 24 der Trägerplatte 10. In diese Öffnung 24 münden die verschiedenen Lichtleiter, so daß keine besonderen Steckkontakte benötigt werden.

Fig. 7 zeigt eine Taste mit einem Schieber 18 und zwei seitlich davon angeordneten Federelementen 25. Das aus dünnem Federstahl gestanzte Element enthält somit als Kombination einerseits einen Schieber 18 und andererseits zwei Federelemente 25, die gemäß Fig. 7a S-förmig gebogen sind. Beide Funktionen sind also in einem Element vereinigt. Durch die schmale Ausführung des Schiebers 18 kann der Abstand der beiden, einander gegenüberliegenden Enden eines Lichtleiters 12 an einer Unterbrechungsstelle klein gehalten werden.

## Ansprüche

1. Tastatur für ein elektrisches Gerät, z. B. für eine elektronische Datenverarbeitungsanlage, zur Beeinflussung von elektrischen Stromkreisen beim Betätigen der Tasten, dadurch gekennzeichnet, daß die Tasten (16) aus einer mit Lichtleitern (12) versehenen Trägerplatte (10) angeordnet sind, daß die Lichtleiter (12) unterhalb jeder Taste (16) zum Einführen eines von der Taste (16) betätigbaren Schiebers (18) unterbrochen sind und daß die Lichtleiter (12) mit Lichtquellen (13) und Lichtempfängern (14) verbindbar sind.

2. Tastatur nach Anspruch 1, dadurch gekennzeichnet, daß die Trägerplatte (10) ein Kunststoffspritzteil ist und eingeprägte Kanäle (11) zur Aufnahme der Lichtleiter (12) aufweist.

3. Tastatur nach Anspruch 1 oder 2, dadurch gekennzeichnet, daß die Lichtleiter (12) in einem Mehrfach-Spritzverfahren hergestellt sind.

4. Tastatur nach Anspruch 1 oder 2, dadurch gekennzeichnet, daß die Lichtleiter (12) durch Eingießen eines lichtleitenden Gels in die Kanäle (11) hergestellt sind.

5. Tastatur nach einem der Ansprüche 1 bis 4, dadurch gekennzeichnet, daß zur Herstellung der Lichtleiter (12) Materialien mit unterschiedlichen Brechungsindizes bei einer hohen Oberflächengüte verwendet werden.

6. Tastatur nach einem der Ansprüche 1 bis 5, dadurch gekennzeichnet, daß die Trägerplatte (10) eingefärbt ist.

7. Tastatur nach einem der Ansprüche 1 bis 6, dadurch gekennzeichnet, daß die Lichtleiter (12) mit den zugehörigen Tasten (T) auf der Trägerplatte (10) in Form einer Matrix angeordnet und derart mit Lichtquellen (Q) und Lichtempfängern (E) verbunden sind, daß jede Lichtquelle (Q) über einen gesonderten, durch je eine Taste (T) unterbrechbaren Lichtleiter (12) mit jedem Lichtempfänger (E) verbunden ist.

8. Tastatur nach einem der Ansprüche 1 bis 7, dadurch gekennzeichnet, daß die Lichtein- und/oder -auskopplung durch eine zirkulare Anordnung der Lichtleiter (12) um die Lichtquelle (13) oder um den Lichtempfänger (14) erfolgt.

9. Tastatur nach einem der Ansprüche 1 bis 7, dadurch gekennzeichnet, daß die Lichtein- und/oder -auskopplung durch eine planare Anordnung der Lichtleiter (12) in bezug auf die Lichtquelle (13) bzw. den Lichtsender (14) erfolgt.

10. Tastatur nach einem der Ansprüche 1 bis 9, dadurch gekennzeichnet, daß die die Lichtleiter (12) enthaltende und die Tasten (16) tragende Trägerplatte (10) auf einer die zugehörige Elektronik enthaltenden Platine (23) befestigt ist und daß der mit der Elektronik-Platine (23) galvanisch verbundene Lichtempfänger oder Lichtsender (13, 14) in eine Öffnung (24) der Trägerplatte (10) ragt, in die die Enden der Lichtleiter (12) einmünden.

11. Tastatur nach einem der Ansprüche 1 bis 10, dadurch gekennzeichnet, daß jede Taste (16) ein aus flachem Federstahl bestehendes Element enthält, des ein als Schieber (18) dienendes, zungenförmiges Mittelteil und beiderseits davon zwei S-förmig gewölbte, als Federelement dienende Seitenteile (25) aufweist.

12. Tastatur nach einem der Ansprüche 1 bis 11, dadurch gekennzeichnet, daß der Schieber (18) einer Taste (16) mehr oder weniger lichtdurchlässig ist, z. B. grau eingefärbt ist.

13. Verfahren zur Steuerung der Lichtquellen bei einer matrixförmigen Anordnung gemäß Anspruch 7, dadurch gekennzeichnet, daß jeder Lichtquelle (Q) ein besonderer, in der Zeit verschobener Puls zugeordnet ist.

Fig. 1

Fig. 2

Fig. 3

SYNCPULSE

CONTROLPULSE

Q 1

Q 2

Qn

Fig. 4

Fig. 5a

Fig. 5b

Fig. 6

Fig. 7a

Fig. 7b

3-Ⅲ-PHD 89-004